# EUROPEAN PATENT APPLICATION

(11) **EP 2 131 157 A1**
(43) Date of publication of application: **09.12.2009**
(21) Application number: 07742474.5
(22) Date of filing: 26.04.2007
(51) Int. Cl.: G01D 5/245

(54) **ANGLE DETECTOR**

(30) Priority: 29.03.2007 JP 2007089789; 25.04.2007 JP 2007116234
(71) Applicant: Tamagawa Seiki CO., LTD., 1879 OhyasumiIida-shi Nagano 395-8515 (JP)
(72) Inventor: KIMURA, Satoshi, Aomori 039-2245 (JP)
(74) Representative: Jenkins, Peter David
(86) International application number: PCT/JP2007/059039
(87) International publication number: WO 2008/120403

(57) **Abstract**

An angle detector with a shaft angle multiplier of 32X shown in Fig. 2 is structured so that the number of winding grooves (2) of a stator core (1) is sixteen which is less than twice the shaft angle multiplier and so that the number of winding grooves (5) of a rotor core (4) is sixty four which is twice the shaft angle multiplier as commonly practiced. One or more small teeth (31) are formed on each tooth (3) of the winding grooves (2). In one embodiment, the number of the small teeth (31) is two for each tooth (3); therefore, the total number of the small teeth (31) is equal to the shaft angle multiplier of 32X. Consequently, even a resolver or a synchro with a large shaft angle multiplier can be easily reduced in size and cost, and wire winding is easily automated.

## Description

### Technical Field

The present invention relates to an angle detector, and more particularly to an angle detector that can be easily reduced in size and cost, and allows easy automated wire winding even when the angle detector is a resolver or a synchro with a large shaft angle multiplier.

### Background Art

Generally, a rotor core and a stator core that constitute a resolver require winding grooves of the number twice a shaft angle multiplier or more. Thus, in production of a resolver with a large shaft angle multiplier, a large number of winding grooves are formed, and sizes of the rotor core and the stator core are increased with increasing number of winding grooves.

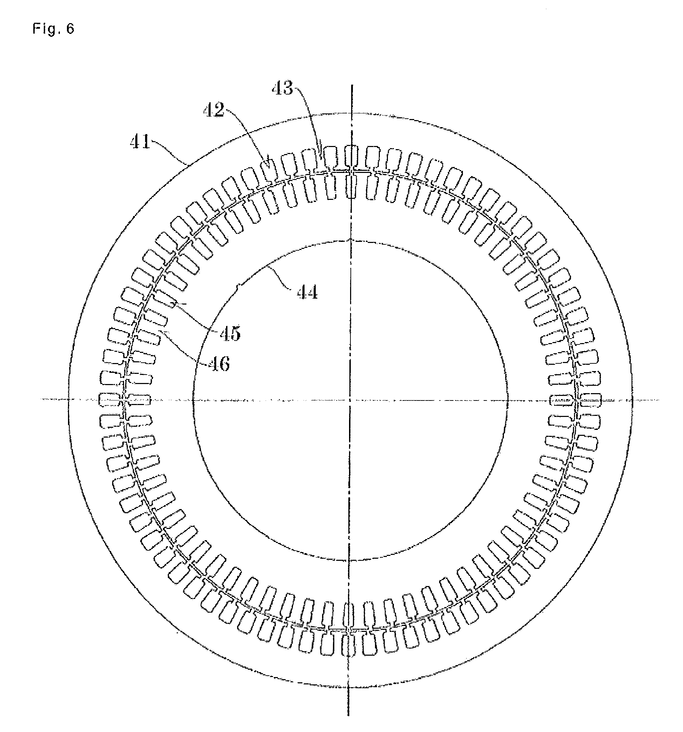

Figure 6 is a plan view of an exemplary configuration of a conventional stator core and rotor core in a resolver with a large shaft angle multiplier. This example shows a resolver with a shaft angle multiplier of 32X, and thus the number of winding grooves 42 of the stator core 41 is 64 and the number of winding grooves 45 of the rotor core 44 is 72 as shown. As such, the resolver with a large shaft angle multiplier is inevitably increased in size according to the size of the shaft angle multiplier.

A proposal of a reduction in size of an angle detector such as a resolver is, for example, disclosed in Patent Document 1. The technique disclosed in the document relates to a configuration in which, to reduce a size in a motor shaft direction of a resolver, a unipolar resolver and a multipolar resolver are placed in the motor shaft direction, a resolver stator of the unipolar resolver is adjacent to a motor stator only with a gap, and a resolver stator of the multipolar resolver is adjacent to the resolver stator of the unipolar resolver only with a gap.

[Patent Document 1]
   Japanese Patent Laid-Open No. 2006-288159 "RESOLVER DEVICE AND MOTOR DEVICE INCLUDING RESOLVER DEVICE"

### Disclosure of the Invention

### Problems to be Solved by the Invention

The technique disclosed in Patent Document 1 proposes the configuration for reducing the size in the motor shaft direction as described above. However, Patent Document 1 and other documents have not proposed a sufficient solution for reducing a radial size of a device with a large shaft angle multiplier.

As described above, in an angle detector such as a resolver with a large shaft angle multiplier, the number of winding grooves is large to increase sizes of a rotor core and a stator core, which prevents a reduction in size of the angle detector and production cost. This also prevents automated wire winding in the angle detector with a large shaft angle multiplier.

In view of the problems of the conventional technique, the present invention has an object to provide an angle detector that can be easily reduced in size and cost, and allows easy automated wire winding even when the angle detector is a resolver or a synchro with a large shaft angle multiplier.

### Means for Solving the Problems

The inventor has studied the problems and found that the problems can be solved by reducing the number of grooves of a rotor core or a stator core on an output side and forming small teeth on each tooth of the core, and reached the present invention. Specifically, the invention claimed in the application as the means for solving the problems is as described below.

(1) An angle detector wherein the number of winding grooves on an output side is less than twice a shaft angle multiplier.
(2) The angle detector according to (1), wherein the number of winding grooves on the output side is equal to or more than the number of phases of windings to be wound.
(3) The angle detector according to (1) or (2), wherein the number of winding grooves of a stator core on the output side is less than twice the shaft angle multiplier.
(4) The angle detector according to (3), wherein one or more small teeth are formed on each tooth of the stator core.
(5) The angle detector according to (1) or (2), wherein the number of winding grooves of a rotor core on the output side is less than twice the shaft angle multiplier.
(6) The angle detector according to (5), wherein one or more small teeth are formed on each tooth of the rotor core.
(7) The angle detector according to any of (1) to (6), wherein windings are wound around the stator core and the rotor core.
(8) The angle detector according to (7), wherein the angle detector is a resolver of any of one-phase excitation/two-phase output, two-phase excitation/one-phase output, and two-phase excitation/two-phase output signal types.

### Advantage of the Invention

The angle detector of the present invention is configured as described above, and thus even a resolver or a synchro with a large shaft angle multiplier can be easily reduced in size and cost. Also, wire winding can be easily automated even in an angle detector with a large shaft angle multiplier.

### Brief Description of the Drawings

Figure 1 is a sectional view of a configuration of a stator in an amplitude modulation type resolver according to an embodiment of an angle detector of the present invention, the angle detector being a resolver with a shaft angle multiplier of 32X;
Figure 2 is a sectional view of the stator core in combination with a rotor core in the resolver with the shaft angle multiplier of 32X in Figure 1;
Figure 3 is a partially sectional end view and a side sectional view of the resolver with the shaft angle multiplier of 32X including the stator core and the rotor core in Figure 2;
Figure 4 illustrates configurations of the stator core and the rotor core in Figure 2 linearly developed;
Figure 5A illustrates a further exemplary configuration of a resolver with a shaft angle multiplier of 32X according to the present invention linearly developed;
Figure 5B illustrates a further exemplary configuration of a resolver with a shaft angle multiplier of 32X according to the present invention linearly developed;
Figure 5C illustrates a further exemplary configuration of a resolver with a shaft angle multiplier of 32X according to the present invention linearly developed;
Figure 5D illustrates a further exemplary configuration of a resolver with a shaft angle multiplier of 32X according to the present invention linearly developed;
Figure 5E illustrates a further exemplary configuration of a resolver with a shaft angle multiplier of 32X according to the present invention linearly developed; and
Figure 6 is a plan view of an exemplary configuration of a conventional stator core and rotor core in a resolver with a large shaft angle multiplier.

### Description of Symbols

- 1: stator core
- 2: winding groove (stator core)
- 3: tooth (stator core)
- 31: small tooth (stator core)
- 4: rotor core
- 5: winding groove (rotor core)
- 6: tooth (rotor core)
- 7: stator side rotation transformer
- 8: rotor side rotation transformer
- 9: shaft
- 10: case
- 13: stator winding
- 16: rotor winding
- 41: stator core
- 42: winding groove (stator core)
- 43: tooth (stator core)
- 44: rotor core
- 45: winding groove (rotor core)
- 46: tooth (rotor core)

### Best Mode for Carrying Out the Invention

The present invention will be described in detail with reference to the drawings. The description will be made below on an example of a resolver that is an amplitude modulation type angle detector with a stator on an output side. However, the present invention may be applied to a phase modulation type resolver with a rotor on an output side, resolvers of one-phase excitation/two-phase output, two-phase excitation/one-phase output, and two-phase excitation/two-phase output signal types, and a synchro.

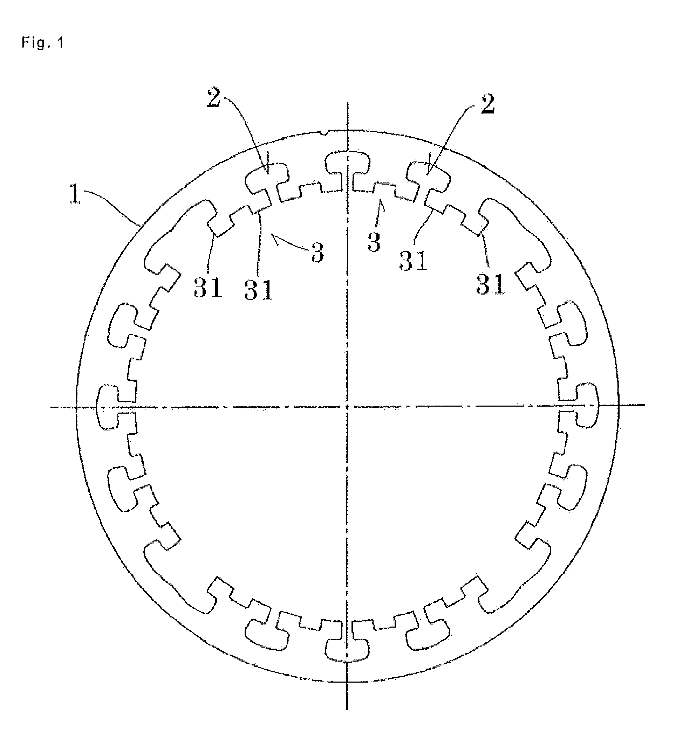

Figure 1 is a sectional view of a configuration of a stator in an amplitude modulation type resolver according to an embodiment of an angle detector of the present invention. The angle detector is a resolver with a shaft angle multiplier of 32X.

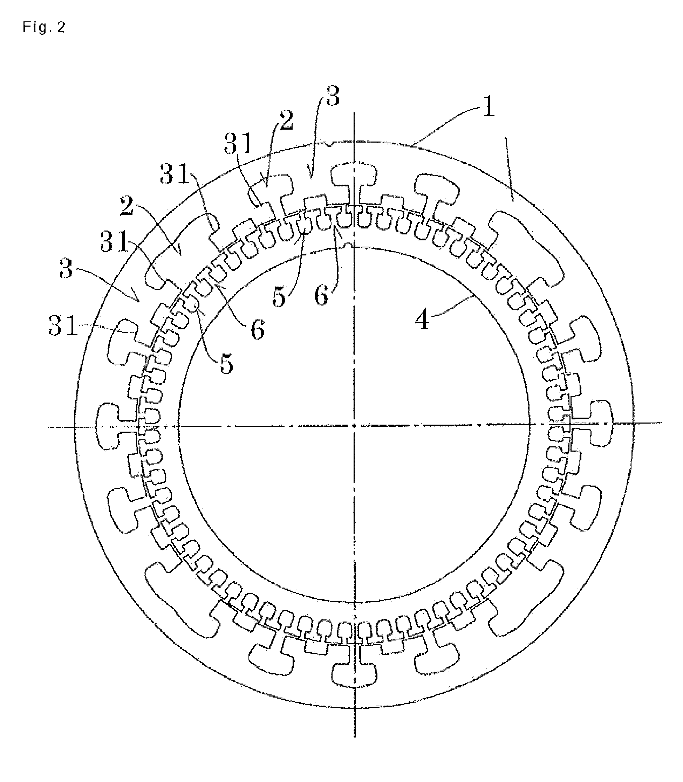

Figure 2 is a sectional view of the stator core in combination with a rotor core in the resolver with the shaft angle multiplier of 32X in Figure 1.

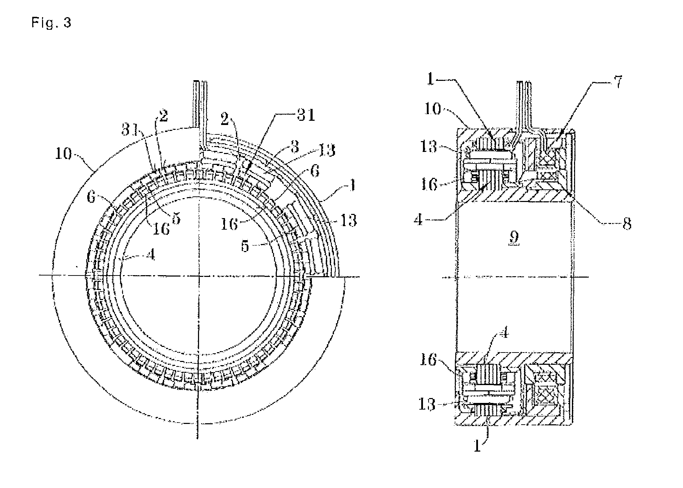

Figure 3 is a partially sectional end view and a side sectional view of the resolver with the shaft angle multiplier of 32X including the stator core and the rotor core in Figure 2. As shown, in the angle detector, the number of winding grooves on an output side is basically less than twice the shaft angle multiplier, for example, the number of winding grooves 2 of the stator core 1 is less than twice the shaft angle multiplier. More specifically, in the embodiment, the number of winding grooves 2 provided is 16 which is less than twice the shaft angle multiplier of 32X.

The angle detector of the present invention has such a configuration, and thus a core on the output side, that is, the stator core 1 in this embodiment can be easily reduced in size, and thus the entire angle detector can be reduced in size. This can also reduce cost. Further, wire winding can be easily automated even in an angle detector with a large shaft angle multiplier. In the embodiment, the angle detector is the resolver with the shaft angle multiplier of 32X, but the present invention may be, of course, applied to angle detectors with a larger shaft angle multiplier or a smaller shaft angle multiplier.

Further, the angle detector of the present invention has a characteristic feature in which a plurality of small teeth 31 are formed on each tooth 3 of the stator core 1 as in the shown example.
Specifically, even with a reduced number of grooves 2 of the stator core 1, an output signal is generated. Thus, even with one small tooth, an output signal is generated. However, two or more small teeth are provided at appropriate intervals to ensure generation of a signal for obtaining a predetermined shaft angle multiplier. When the number of grooves 2 is 16 with the shaft angle multiplier of 32X as in the embodiment, the number of small teeth 31 on one groove may be 2.

In the shown example, two small teeth 31 are provided on one groove 2 of the stator core, but the present invention is not limited to this, and three or more small teeth may be provided. For example, when the number of grooves of the stator core is 8 with the same shaft angle multiplier of 32X, the number of small teeth provided on each groove may be 4. When the number of grooves of the stator core is 4, the number of small teeth provided on each groove may be 8, as appropriate.

As shown in Figures 2 and 3, in the angle detector of the embodiment with the shaft angle multiplier of 32X, 64 winding grooves 5 which is twice the shaft angle multiplier of 32X are provided on the rotor core 4. On the other hand, 16 winding grooves 2 which is one half the shaft angle multiplier are provided on the stator core 1 as described above, and two small teeth 31 are provided on one tooth 3.

As in the embodiment, in the angle detector of the present invention, winding grooves (and teeth) twice the shaft angle multiplier are provided on one of the stator core and the rotor core without the number of winding grooves being reduced.

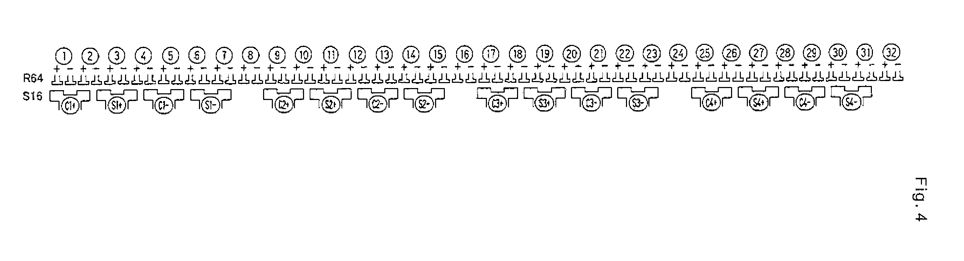

Figure 4 illustrates configurations of the stator core and the rotor core in Figure 2 linearly developed.

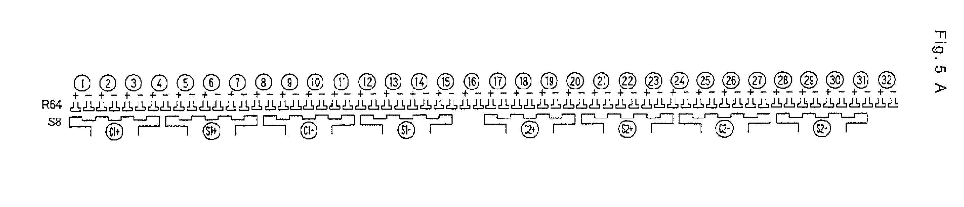

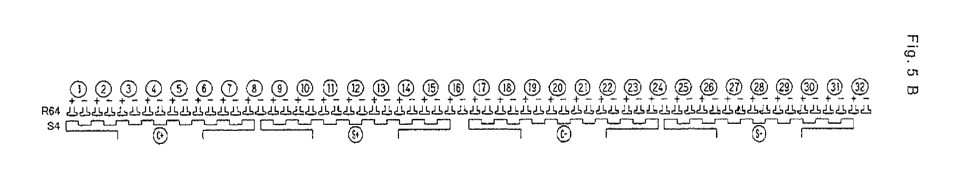

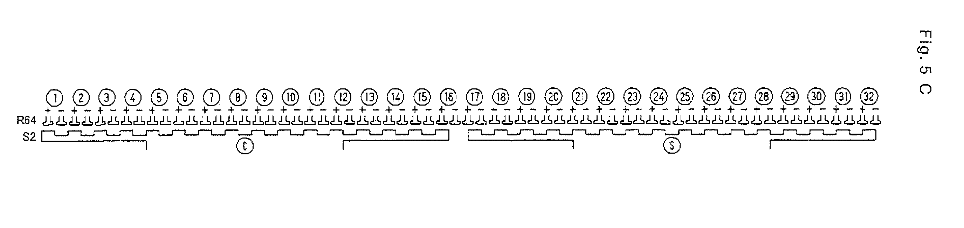

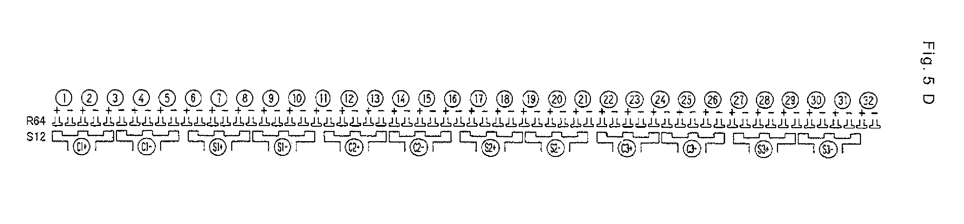

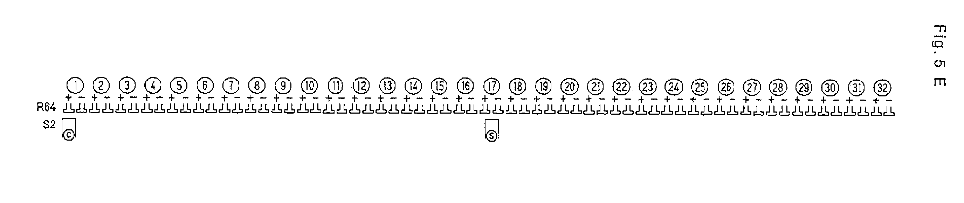

Figures 5A to 5E illustrate further exemplary configurations of a resolver with a shaft angle multiplier of 32X according to the present invention linearly developed. In the drawings, "R" on the left end refers to a rotor and "S" refers to a stator. "R64" refers to a rotor with 64 grooves and "S8" refers to a stator with 8 grooves. The same applies to other indications of "R (or S) and numeral". Circled "S" and "C" on the rotor in the drawings indicate that teeth with the circled characters are teeth around which a sinusoidal winding and a cosine winding, respectively, are wound.

As shown in the examples in Figures 5A to 5E, the number of grooves of the rotor core on an excitation side is 64 which is twice the shaft angle multiplier, but the number of grooves of the stator core on the output side may be reduced to 2, 4, 8 or 12. Also, one or more small teeth may be provided on each tooth, and the number of small teeth may be 2, 3, 4, 8 or 16 as appropriate. The number of grooves of the output side core and the number of small teeth are not limited to those in the shown examples. A configuration without a small tooth as in the example at the bottom in which the number of grooves of the stator cores is 2 also falls within the scope of the present invention.

Specifically, the present invention includes a configuration in which grooves as detection portions of output signals are provided at intervals rather than a conventional configuration in which grooves are provided around the entire circumference of an output side core for angle resolution, thereby achieving a reduction in size and automated wire winding.

The present invention has been described above on the angle detector with the stator on the output side, but the present invention may be applied to an angle detector with a rotor on an output side as described above. In this case, the number of winding grooves of the rotor core may be less than twice a shaft angle multiplier, while the number of winding grooves of a stator core may be twice the shaft angle multiplier, and one or more small teeth may be formed on each tooth of the rotor core.

### Industrial Applicability

The angle detector of the present invention can be easily reduced in size and cost even when the angle detector is a resolver or a synchro with a large shaft angle multiplier, and can be applied to a wider range of uses. Also, even with a large shaft angle multiplier, wire winding can be automated, and thus the angle detector of the present invention is advantageous in production processes and has many uses in industry.

## Claims

1. An angle detector **characterized in that** the number of winding grooves on an output side is less than twice a shaft angle multiplier.

2. The angle detector according to claim 1, **characterized in that** the number of winding grooves on the output side is equal to or more than the number of phases of windings to be wound.

3. The angle detector according to claim 1 or 2, **characterized in that** the number of winding grooves of a stator core on the output side is less than twice the shaft angle multiplier.

4. The angle detector according to claim 3, **characterized in that** one or more small teeth are formed on each tooth of the stator core.

5. The angle detector according to claim 1 or 2, **characterized in that** the number of winding grooves of a rotor core on the output side is less than twice the shaft angle multiplier.

6. The angle detector according to claim 5, **characterized in that** one or more small teeth are formed on each tooth of the rotor core.

7. The angle detector according to any of claims 1 to 6, wherein windings are wound around the stator core and the rotor core.

8. The angle detector according to claim 7, **characterized in that** the angle detector is a resolver of any of one-phase excitation/two-phase output, two-phase excitation/one-phase output, and two-phase excitation/two-phase output signal types.
